# EUROPEAN PATENT APPLICATION

(11) **EP 4 009 348 A1**
(43) Date of publication of application: **08.06.2022**
(21) Application number: 20210844.5
(22) Date of filing: 01.12.2020
(51) Int. Cl.: H01J 37/244

(54) **CHARGED PARTICLE INSPECTION TOOL AND METHOD**

(71) Applicant: ASML Netherlands B.V., 5500 AH Veldhoven (NL)
(72) Inventor: VEENSTRA, Roy, Ramon, 5500 AH Veldhoven (NL)
(74) Representative: ASML Netherlands B.V.

(57) **Abstract**

A multi-beam electron-optical system for a charged-particle assessment tool, the system comprising:
an objective lens array assembly comprising a plurality of objective lenses, each configured to project one of a plurality of charged-particle beams onto a sample;
a detector array associated with the objective lens array assembly and configured to detect charged-particles emitted from the sample; and
a circuit comprising an amplifier in data communication with the detector array;
wherein the amplifier is configured to be tunable in order to tune amplification of signals from the detector array.

## Description

### FIELD

The embodiments provided herein generally relate to charged-particle assessment tools, inspection methods and images, and particularly to charged-particle assessment tools and inspection methods that use multiple sub-beams of charged particles.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

There is a general need to improve the quality of the images that can be obtained by charged-particle assessment tools. In particular it is desirable to be able to increase the level of detail of the image.

### SUMMARY

It is an object of the present disclosure to provide embodiments that support improvement of detail or other characteristics of images that can be obtained by charged-particle assessment tools.

According to a first aspect of the invention, there is provided a multi-beam electron-optical system for a charged-particle assessment tool, the system comprising:
an objective lens array assembly comprising a plurality of objective lenses, each configured to project one of a plurality of charged-particle beams onto a sample;
a detector array associated with the objective lens array assembly and configured to detect charged-particles emitted from the sample; and
a circuit comprising an amplifier in data communication with the detector array;
wherein the amplifier is configured to be tunable in order to tune amplification of signals from the detector array.

According to a second aspect of the invention there is provided a multi-beam electron-optical system for a charged-particle assessment tool, the system comprising:
a current detector array configured to detect charged-particles emitted from a sample by reference to their charge; and
a circuit comprising an amplifier in data communication with the detector array;
wherein the amplifier is configured to be tunable in order to tune amplification of signals from the detector array.

According to a third aspect of the invention there is provided a method for assessing a sample surface with a plurality of sub-beams, the method comprising:
projecting, by use of an objective lens array assembly, the sub-beams onto a surface of a sample;
detecting, by a detector array associated with the objective lens array assembly, charged-particles emitted from the sample; and
amplifying, by an amplifier, signals from the detector array,
wherein the amplifier is configured to be tunable in order to tune the amplification of the signals from the detector array.

According to a fourth aspect of the invention there is provided a method for assessing a sample surface with a plurality of sub-beams, the method comprising:
projecting the sub-beams onto a surface of a sample;
detecting, by a detector array, a current charged-particles emitted from the sample by reference to their charge; and
amplifying, by an amplifier, signals from the detector array,
wherein the amplifier is configured to be tunable in order to tune the amplification of the signals from the detector array.

According to a fifth aspect of the invention there is provided an image of a sample formed from data from a charged-particle assessment tool, the image comprising:
a plurality of image areas formed from data from respective detectors of the charged-particle assessment tool, the data indicating a current of charged-particles emitted from a respective area of the sample,
wherein the image areas comprise the same number of gradations corresponding to different currents of charged-particles emitted from the sample.

### BRIEF DESCRIPTION OF FIGURES

The above and other aspects of the present disclosure will become more apparent from the description of exemplary embodiments, taken in conjunction with the accompanying drawings.
**FIG.** 1 is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary multi-beam apparatus according to an embodiment.
**FIG. 4** is a schematic cross-sectional view of an objective lens of an inspection apparatus according to an embodiment.
**FIG. 5** is a schematic cross-sectional view of an objective lens of an inspection apparatus according to an alternative embodiment.
**FIG. 6** is bottom view of the objective lens of **FIG. 4** or **FIG. 5****.**
**FIG. 7** is a bottom view of a modification of the objective lens of **FIG. 4** or **FIG. 5****.**
**FIG. 8** is an enlarged schematic cross-sectional view of a detector incorporated in the objective lens of **FIG. 4** or **FIG. 5****.**
**FIG. 9** is a schematic diagram of an exemplary electron-optical system comprising a macro collimator and macro scan deflector.
**FIG. 10** is a schematic diagram of an exemplary circuit incorporated in a multi-beam apparatus according to an embodiment.
**FIG. 11** is a schematic diagram of part of an exemplary circuit incorporated in a multi-beam apparatus according to an embodiment.
**FIG. 12** is a schematic diagram of an exemplary multi-beam apparatus according to an embodiment.
**FIG. 13** is a schematic diagram of part of the multi-beam apparatus of **FIG. 12****.**
**FIG. 14** is a schematic diagram of an exemplary multi-beam apparatus according to an embodiment.
**FIG. 15** is an exemplary image.
**FIG. 16** is a version of the image of **FIG. 15** in which signals for different quadrants have been amplified by different factors.
**FIG. 17** is a version of the image of **FIG. 16** in which post-processing has been performed to correct the brightness range.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

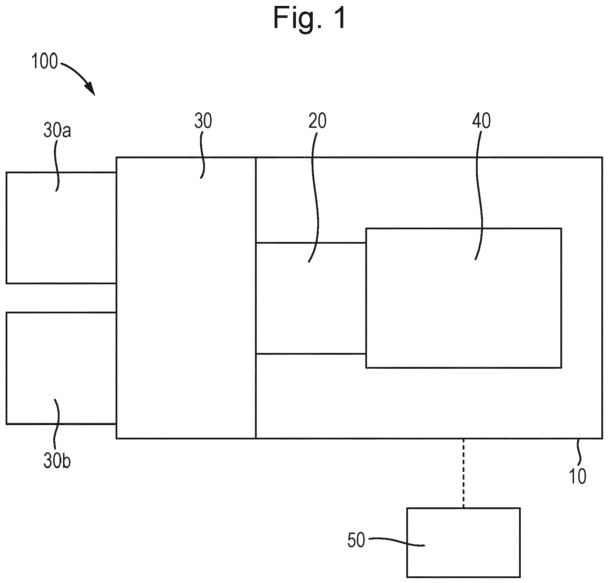

Reference is now made to **FIG. 1**, which is a schematic diagram illustrating an exemplary charged particle beam inspection apparatus 100. The charged particle beam inspection apparatus 100 of **FIG. 1** includes a main chamber 10, a load lock chamber 20, an electron beam tool 40, an equipment front end module (EFEM) 30 and a controller 50. The electron beam tool 40 is located within the main chamber 10.

The EFEM 30 includes a first loading port 30a and a second loading port 30b. EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam tool by which it may be inspected. An electron beam tool 40 may comprise a multi-beam electron-optical apparatus.

The controller 50 is electronically connected to the electron beam tool 40. The controller 50 may be a processor (such as a computer) configured to control the charged particle beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

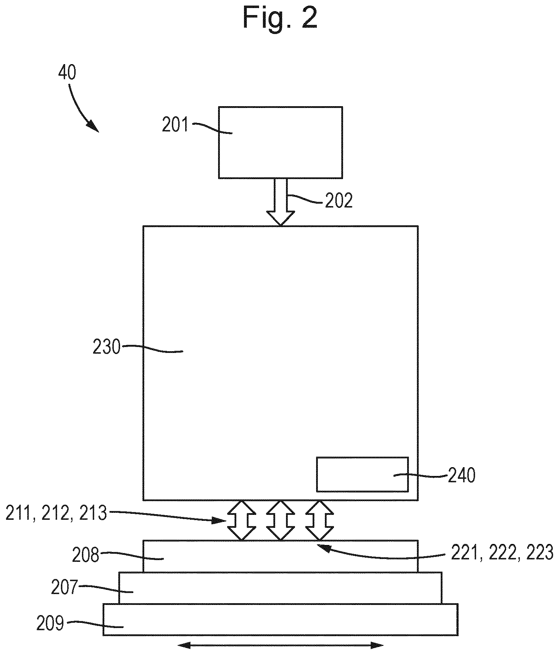

Reference is now made to **FIG. 2**, which is a schematic diagram illustrating an exemplary electron beam tool 40 including a multi-beam inspection tool that is part of the exemplary charged particle beam inspection apparatus 100 of **FIG. 1****.** The multi-beam electron beam tool 40 (also referred to herein as apparatus 40) comprises an electron source 201, a projection apparatus 230, a motorized stage 209, and a sample holder 207. The electron source 201 and projection apparatus 230 may together be referred to as an illumination apparatus. The sample holder 207 is supported by motorized stage 209 so as to hold a sample 208 (e.g., a substrate or a mask) for inspection. The multi-beam electron beam tool 40 further comprises a detector array 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam inspection apparatus 100 of **FIG. 1**, such as the electron source 201, the detector array 240, the projection apparatus 230, and the motorized stage 209. The controller 50 may perform various image and signal processing functions. The controller 50 may also generate various control signals to govern operations of the charged particle beam inspection apparatus, including the charged particle multi-beam apparatus.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy ≤ 50 eV and backscattered electrons typically have electron energy between 50 eV and the landing energy of the primary sub-beams 211, 212, and 213.

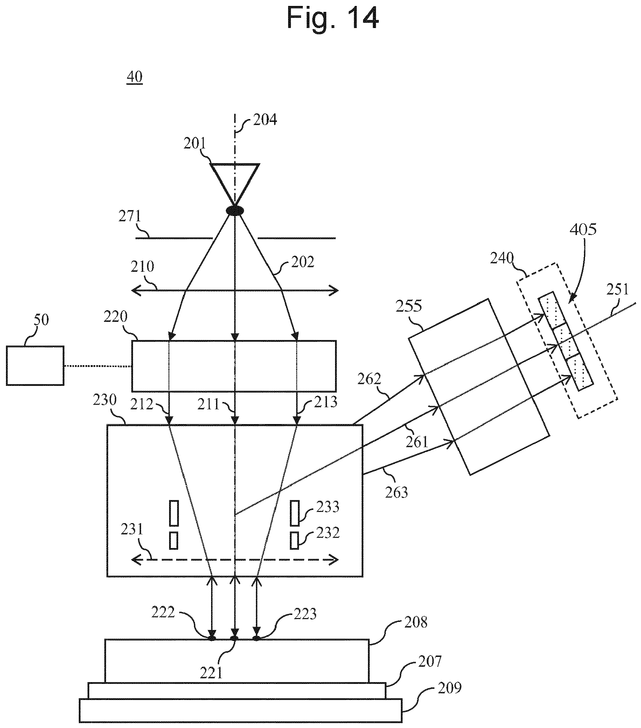

The detector array 240 is configured to detect secondary electrons and/or backscattered electrons and to generate corresponding signals which are sent to a signal processing system (not shown), e.g. to construct images of the corresponding scanned areas of sample 208. The detector array 240 may be incorporated into the projection apparatus 230. Alternatively, as shown in **FIG. 14** the detector array 240 or may be separate from the projection apparatus 230, with a secondary optical column being provided to direct secondary electrons and/or backscattered electrons to the electron detection device.

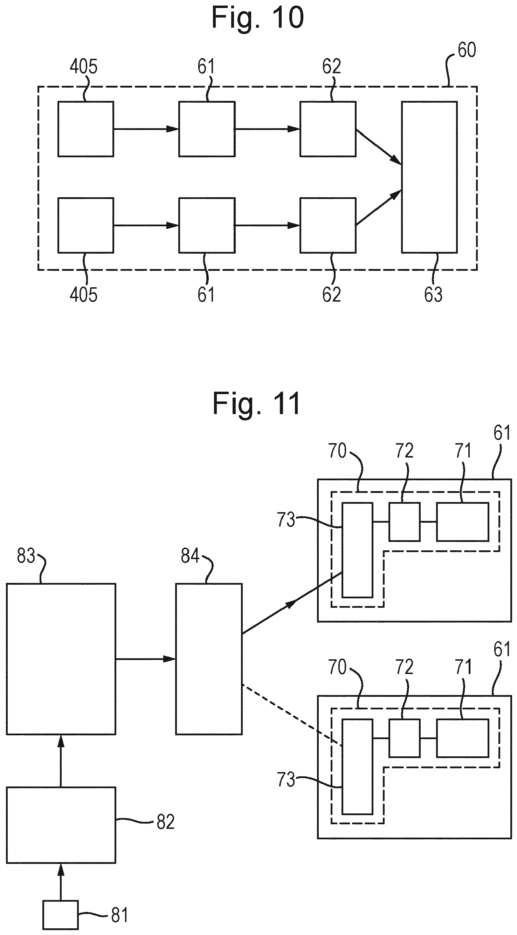

The signal processing system may comprise a circuit 60 (shown in **FIG. 10**) configured to process signals from the detector array 240 so as to form an image. The signal processing system may be incorporated into a component of the column such as the detector array 240 or part of the projection apparatus 230. Alternatively, the signal processing system may be incorporated into the controller 50. The image processing system may include an image acquirer (not shown) and a storage device (not shown). For example, the image processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector array 240 permitting signal communication, such as an electrical conductor, optical fiber cable, portable storage media, IR, Bluetooth, internet, wireless network, wireless radio, among others, or a combination thereof. The image acquirer may receive a signal from the detector array 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the detector array 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of the sample 208. Each imaging area may correspond to secondary electrons resulting from a respective sub-beam 211-213. The acquired images may comprise multiple images of a single imaging area of the sample 208 sampled multiple times over a time period. The multiple images may be stored in the storage. The image processing system may be configured to perform image processing steps with the multiple images of the same location of the sample 208.

The image processing system may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the motorized stage 209 to move sample 208 during inspection of the sample 208. The controller 50 may enable the motorized stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

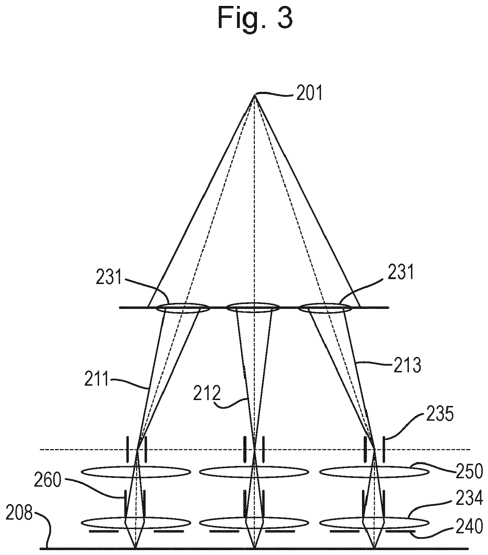

**FIG. 3** is a schematic diagram of an assessment tool. The electron source 201 directs electrodes toward an array of condenser lenses 231 forming part of the projection system 230. The electron source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect. Voltage sources are configured to apply potentials to respective electrodes. A further voltage source may be connected to the sample 208 to apply a potential. Potentials can be defined relative to the sample 208 and/or the source 201.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens 231 in the array directs electrons into a respective sub-beam 211, 212, 213 which is focused at a respective intermediate focus. The sub-beams diverge with respect to each other. The sub-beam paths diverge down beam of the condenser lenses 231. In an embodiment deflectors 235 are provided at the intermediate focuses. The deflectors 235 are positioned in the beamlet paths at, or at least around, the position of the corresponding intermediate focusses 233 or focus points (i.e. points of focus). The deflectors are positioned in or close to the beamlet paths at the intermediate image plane of the associated sub-beam. The deflectors 235 are configured to operate on the respective sub-beams 211, 212, 213. The deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the beamlets so that before the deflectors, the beamlets paths with respect to each other are diverging. Down beam of the deflectors the beamlet paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array.

Below (i.e. downbeam or further from source 201) the deflectors 235 there is a control lens array 250 comprising a control lens for each sub-beam 211, 212, 213. The control lens array 250 may comprise three plate electrode arrays connected to respective potential sources. A function of the control lens array 250 is optimize the beam opening angle with respect to the demagnification of the beam and/or to control the beam energy delivered to the objective lenses 234, each of which directs a respective sub-beam 211, 212, 213 onto the sample 208.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

Optionally an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

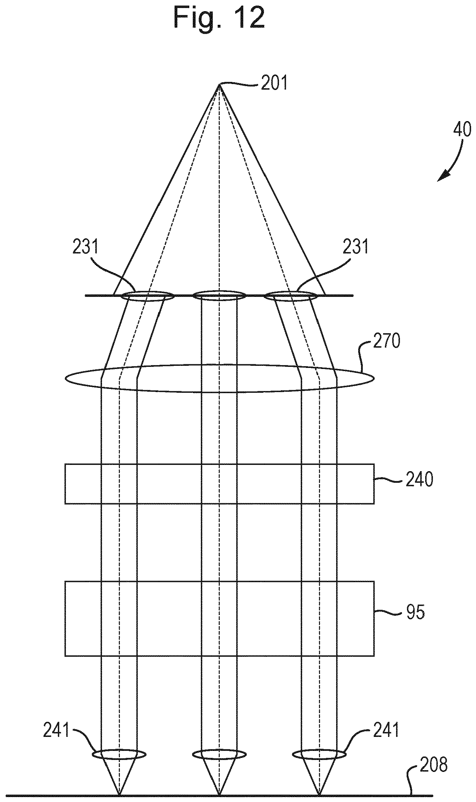

A detector array 240 is provided to detect secondary and/or backscattered electrons emitted from the sample 208. In an embodiment, the detector array 240 is between the objective lenses 234 and the sample 208. However, other positions for the detector array 240 are possible, as shown in **FIG. 12** and **FIG. 14****,** for example. An exemplary construction of the detector array 240 is described below.

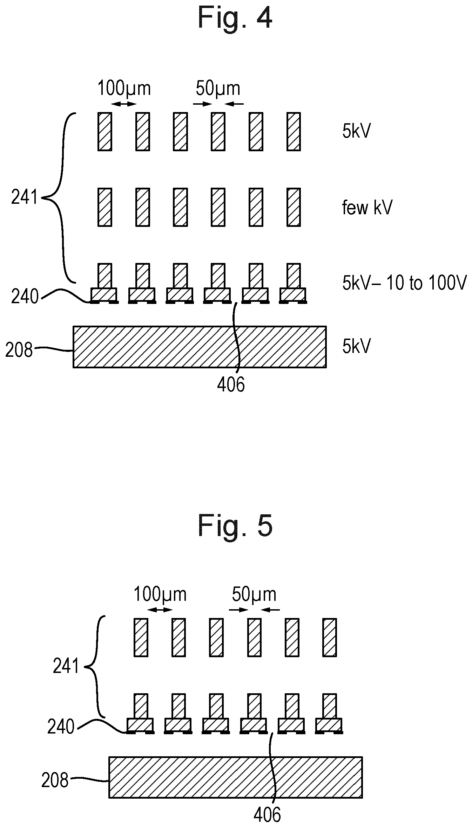

An exemplary embodiment of a detector array integrated into an objective lens array is shown in **FIG. 4** which illustrates a portion of a multibeam objective lens array 240 in schematic cross section. In this embodiment, the detector array 240 a plurality of detector elements 405 (e.g. sensor elements such as capture electrodes). In this embodiment, the detector array 240 is provided on an output side of the objective lens array 241. The output side is the output side of the objective lens array 241.

The objective lens array 241 can be configured to demagnify the electron beam by a factor greater than 10, desirably in the range of 50 to 100 or more. The objective lens array 241 may comprise a middle electrode, a lower electrode and an upper electrode. The middle, lower and upper electrodes are each provided with an aperture through which the respective sub-beam propagates. The potential for the lower electrode can be similar to the potential of the sample 208. Thus, with three electrodes, the objective lens array may be an array of Einzellenses.

As shown in **FIG. 5**, in an embodiment relative to the embodiment shown in **FIG. 4** one of the electrodes can be omitted. An objective lens array 240 having only two electrodes can have lower aberration than an objective lens array 240 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. A benefit of two electrode lens over an Einzel lens is that the energy of an in-coming beam is not necessarily the same as an out-going beam. Beneficially the potential differences on such a two electrode lens array enables it to function as a decelerating lens array.

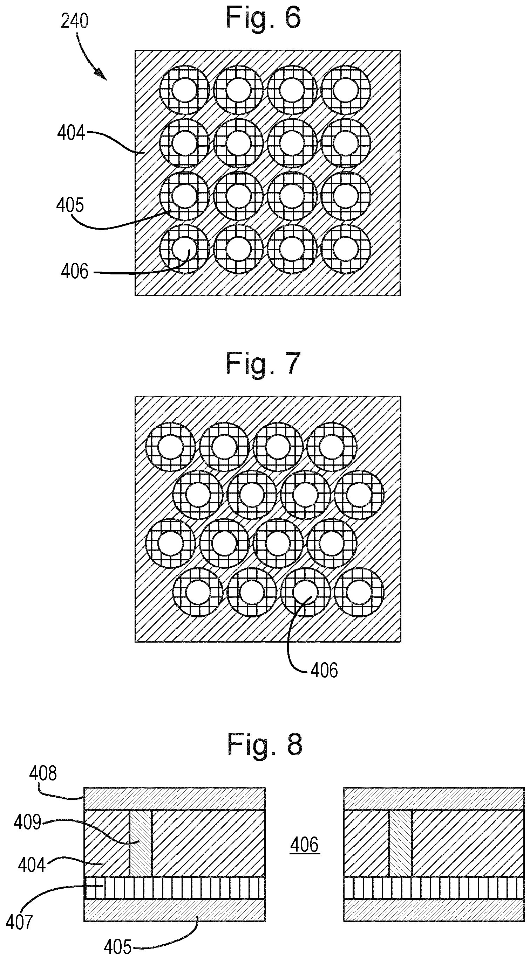

**FIG. 6** is a bottom view of the detector array 240 which comprises a substrate 404 on which are provided a plurality of detector elements 405 each surrounding a beam aperture 406. The beam apertures 406 may be formed by etching through the substrate 404. In the arrangement shown in **FIG. 6**, the beam apertures 406 are shown in a rectangular array. The beam apertures 406 can also be differently arranged, e.g. in a hexagonal close packed array as depicted in **FIG. 7****.** The beam arrangement of the hexagonal arrangement in **FIG. 7** may be more densely packed than the square beam arrangement as shown in **FIG. 6****.**

**FIG. 8** depicts at a larger scale a part of the detector array 240 in cross section. The detector elements 405 form the bottommost, i.e. most close to the sample 208, surface of the detector array 240. Between the detector elements 405 and the main body of the substrate 404 a logic layer 407 is provided. At least part of the image processing system may be incorporated into the logic layer 407. The logic layer 407 may comprise at least part of the circuit 60 that embodies at least part of the image processing system. The logic layer 407 may include amplifiers, e.g. Trans Impedance Amplifiers (TIAs), analogue to digital converters, and readout logic. In an embodiment, there is one amplifier and one analogue to digital converter per detector element 405. The logic layer 407 and the detector elements 405 can be manufactured using a CMOS process with the detector elements 405 forming the final metallisation layer.

A wiring layer 408 is provided on the backside of, or within, the substrate 404 and connected to the logic layer 407 by through-substrate vias 409. The number of through-substrate vias 409 need not be the same as the number of beam apertures 406. In particular if the electrode signals are digitized in the logic layer 407 only a small number of through-silicon vias may be required to provide a data bus. The wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector array 240.

The integrated detector array described above is particularly advantageous when used with a tool having tunable landing energy as secondary electron capture can be optimized for a range of landing energies. A detector array can also be integrated into other electrode arrays, not only the lowest electrode array. Further details and alternative arrangements of a detector module integrated into an objective lens can be found in EP Application Number 20184160.8, which document is hereby incorporated by reference.

In an embodiment each element in the objective lens array 240 is a micro-lens operating a different beam or group of beams in the multi-beam. The objective lens array 240 has at least two plates each with a plurality of holes or apertures. The position of each hole in a plate corresponds to the position of a corresponding hole in the other plate. The corresponding holes operate in use on the same beam or group of beams in the multi-beam. A suitable example of a type of lens for each element in the array is a two electrode decelerating lens.

In some embodiments, the detector array 240 of the objective lens array assembly is down-beam of at least one electrode of the objective lens array 241. In an embodiment, at least a portion of the detector (e.g. the detector module) is adjacent to and/or integrated with the objective lens array 240. For example, the detector array may be implemented by integrating a CMOS chip detector into a bottom electrode of the objective lens array. Integration of a detector array into the objective lens array 240 or other component of the primary column replaces a secondary column. The CMOS chip is preferably orientated to face the sample (because of the small distance (e.g. 200µm or less, 100µm or less or 50 µm or less) between wafer and bottom of the electron-optical system). In an embodiment, detector elements 405 to capture the secondary electrons are formed in the surface metal layer of the CMOS device. The detector elements 405 can be formed in other layers. Power and control signals of the CMOS may be connected to the CMOS by through-silicon vias. For robustness, preferably a passive silicon substrate with holes shields the CMOS chip from high E- fields.

In order to maximize the detection efficiency it is desirable to make the surface of the detector elements 405 as large as possible, so that substantially all the area of the objective lens array 240 (excepting the apertures) is occupied by detector elements 405 and each detector element 405 has a diameter substantially equal to the array pitch. In an embodiment the outer shape of the detector element 405 is a circle, but this can be made a square to maximize the detection area. Also the diameter of the through-substrate via 409 can be minimized. A typical size of the electron beam is in the order of 5 to 15 micron.

In an embodiment, a single detector element 405 surrounds each beam aperture 406. In another embodiment, a plurality of detector elements 405 are provided around each beam aperture 406. The electrons captured by the detector elements 405 surrounding one beam aperture 406 may be combined into a single signal or used to generate independent signals. The detector elements 405 may be divided radially (i.e. to form a plurality of concentric annuluses), angularly (i.e. to form a plurality of sector-like pieces), both radially and angularly or in any other convenient manner.

However a larger surface for the detector elements 405 leads to a larger parasitic capacitance, so a lower bandwidth. For this reason it may be desirable to limit the outer diameter of the detector elements 405. Especially in case a larger detector element 405 gives only a slightly larger detection efficiency, but a significantly larger capacitance. A circular (annular) detector element 405 may provide a good compromise between collection efficiency and parasitic capacitance.

A larger outer diameter of the detector element 405 may also lead to a larger crosstalk (sensitivity to the signal of a neighboring hole). This can also be a reason to make the outer diameter of the detector element 405 smaller. Especially in case a larger detector element 405 gives only a slightly larger detection efficiency, but a significantly larger crosstalk.

The back-scattered and/or secondary electron current collected by detector element 405 is amplified, for example by an amplifier such as a TIA.

In some embodiments, the charged particle assessment tool further comprises one or more aberration correctors that reduce one or more aberrations in the sub-beams. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

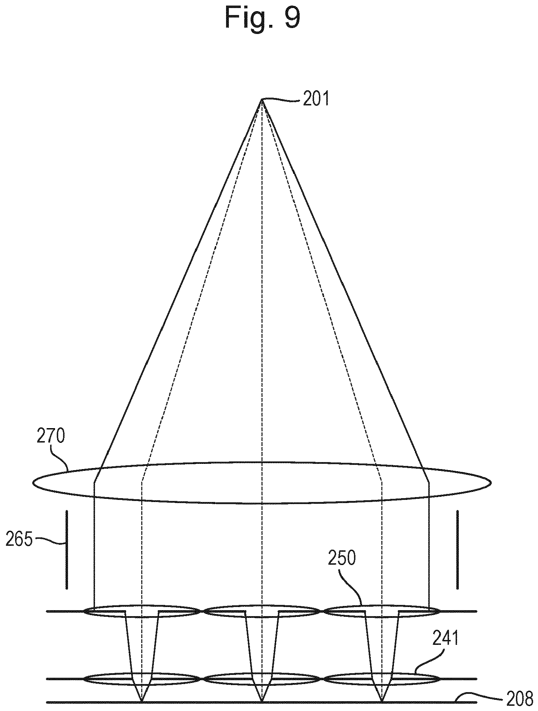

**FIG. 9** is a schematic diagram of an exemplary electron-optical system having the objective lens array assembly. The objective lens array assembly comprises the objective lens array 241. The objective lens array 241 comprises a plurality of objective lenses. For conciseness, features of the objective lens array 241 that have already been described above may not be repeated here.

The objective lens array assembly may further comprise a control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams. (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

In an embodiment, an electron-optical system comprising the objective lens array assembly is configured to control the objective lens assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. In other embodiments, the objective lens array assembly may be configured to form an intermediate focus between the control lens array 250 and the objective lens array 241.

In an embodiment, the control lens array is an exchangeable module, either on its own or in combination with other elements such as the objective lens array and/or detector array. The exchangeable module may be field replaceable, i.e. the module can be swapped for a new module by a field engineer. In an embodiment, multiple exchangeable modules are contained within the tool and can be swapped between operable and non-operable positions without opening the tool.

In an embodiment the exchangeable module comprises an electron-optical component which is on a stage permitting actuation for positioning of the component. In an embodiment the exchangeable module comprises a stage. In an arrangement the stage and the exchangeable module may be an integral part of the electron-optical tool 40. In an arrangement the exchangeable module is limited to the stage and the electron-optical device it supports. In an arrangement the stage is removable. In an alternative design the exchangeable module comprising the stage is removable. The part of the electron-optical tool 40 for the exchangeable module is isolatable, that is the part of the electron-optical tool 40 is defined by a valve up-beam and a valve down-beam of the exchangeable module. The valves can be operated to isolate the environment between the valves from the vacuum up-beam and down-beam of the valves respectively enabling the exchangeable module to be removed from the electron-optical tool 40 whilst maintaining the vacuum up-beam and down-beam of the part of the column associated with the exchangeable module. In an embodiment the exchangeable module comprises a stage. The stage is configured to support an electron-optical device relative to the beam path. In an embodiment the module comprises 405 one or more actuators. The actuators are associated with the stage. The actuators are configured to move the electron-optical device relative to the beam path. Such actuation may be used to align the electron-optical device and the beam path with respect to each other.

In an embodiment, the exchangeable module is a microelectromechanical systems (MEMS) module. MEMS are miniaturized mechanical and electromechanical elements that are made using microfabrication techniques. In an embodiment, the exchangeable module is configured to be replaceable within the electron-optical tool 40. In an embodiment, the exchangeable module is configured to be field replaceable. Field replaceable is intended to mean that the module may be removed and replaced with the same or different module while maintaining the vacuum in which the electron-optical tool 40 is located. Only a section of the column is vented corresponding to the module is vented for the module to be removed and returned or replaced.

The control lens array 250 may be in the same module as an objective lens array 241, i.e. forming an objective lens array assembly or objective lens arrangement, or it may be in a separate module

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise 2 or 3 or more electrodes. If there are two electrodes then the demagnification and landing energy are controlled together. If there are three or more electrodes the demagnification and landing energy can be controlled independently. The control lenses may thus be configured to adjust the demagnification and/or beam opening angle of respective sub-beams (e.g. using the electric power source to apply suitable respective potentials to the electrodes of the control lenses and the objective lenses). This optimization can be achieved with having an excessively negative impact on the number of objective lenses and without excessively deteriorating aberrations of the objective lenses (e.g. without increasing the strength of the objective lenses).

In another arrangement (not shown), the macro-collimator may be partially or wholly replaced by a collimator element array is provided down-beam of the upper beam limiter. Each collimator element collimates a respective sub-beam. The collimator element array may be formed using MEMS manufacturing techniques so as to be spatially compact. The collimator element array may be the first deflecting or focusing electron-optical array element in the beam path down-beam of the source 201. The collimator element array may be up beam of the control lens array 250. The collimator element array may be in the same module as the control lens array 250.

In the embodiment of **FIG. 9****,** the electron-optical system comprises a source 201. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current. In the example shown, a collimator is provided up-beam of the objective lens array assembly. The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses..

In the embodiment of **FIG. 9** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In another arrangement (not shown), the macro scan deflector may be partially or wholly replaced by a scan deflector array. The scan-deflector array 260 comprises a plurality of scan deflectors. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). The scan deflector array may be up beam of an objective lens array 241. The scan deflector array may be down beam of a control lens array 250. Although reference is made to a single sub-beam associated with a scan deflector, groups of sub-beams may be associated with a scan deflector. In an embodiment, the scanning deflectors described in EP2425444, which document is hereby incorporated by reference in its entirety specifically in relation to scan deflectors, may be used to implement the scan-deflector array. A scan-deflector array (e.g. formed using MEMS manufacturing techniques as mentioned above) may be more spatially compact than a macro scan deflector. The scan deflector array may be in the same module as the objective lens array 241.

In other embodiments both a macro scan deflector 265 and the scan-deflector array are provided. In such an arrangement, the scanning of the sub-beams over the sample surface may be achieved by controlling the macro scan deflector and the scan-deflector array 260 together, preferably in synchronization

The objective lens array assembly may further comprise a collimator array and/or a scan deflector array.

Any of the objective lens array assemblies described herein may further comprise a detector array 240. The detector array 240 detects charged particles emitted from the sample 208. The detected charged particles may include any of the charged particles detected by an SEM, including secondary and/or backscattered electrons emitted from the sample 208.

In an embodiment the multi-beam electron-optical system, for example according to the arrangement shown and described with reference to Figs 3 or 9, comprises a circuit 60. The circuit 60 is configured to perform at least part of the function of the image processing system. **FIG. 10** is a schematic diagram of a circuit according to an embodiment. **FIG 10** can be considered as a pictorial representation of a data path for the signal from each detector element in the detector array, or at least a first portion of the data path. In an embodiment the circuit 60 comprises a amplifier 61. The amplifier 61 is in data communication with the detector array 240. In **FIG. 10****,** the lines of data communication are shown as solid lines between components with arrows showing the direction of flow of data. In an embodiment, the amplifier 61 is in data communication with one of the detector elements 405 of the detector array 240.

In **FIG. 10****,** two amplifiers 61 are shown connected to respective detector elements 405. In an embodiment, an amplifier 61 is provided for each detector element 405. There may be hundreds (100s), thousands (1,000s) or tens of thousands (10,000s) of detector elements 405 and associated amplifiers 61, for example associated with an electron-optical column. For conciseness, only two are shown in **FIG. 10****.** The measurement of secondary electrons made by the detector element 405 is transmitted as a signal to the amplifier 61. The amplifier 61 is configured to apply an amplification factor to the signal.

As shown in **FIG. 10****,** the amplified signal is output by the amplifier 61 to an analog-to-digital converter (ADC) 62. The ADC 62 is configured to convert the amplified signal into a digital signal. In an embodiment the ADC 62 is configured to output the converted digital signal to a serializer 63. The signals from a plurality of detector elements 405 are provided to the serializer 63. In an embodiment the serializer 63 is configured to serialize the converted digital signals. The serialized signals are used to form an image of the sample 208, for example by signal processing the signals.

In an embodiment, the amplifier 61 is configured to be tunable in order to tune amplification of signals from the detector array 240. The amplification factor applied by the amplifier 61 can be adjusted independently of the amplification factor of the other amplifiers 61. Note that the strength of the signals from the detector elements of detector are not necessarily the same. It is to be expected a variation in the signal strengths of the detector elements.

By tuning the amplifier 61, it is possible to control the amplification of the signal so as to increase the proportion of the input range of the ADC 62 that is used. If the amplification factor is too low, then part of the potential input range of the ADC 62 remains unused. As a result, the range of different possible values that can be output by the ADC 62 to the serializer 63 is less than its maximum. This results in a loss of information in the image that is generated from the serialized signals. The resolution of the image is reduced in that the number of possible gradations for the section of the image that corresponds to the amplifier 61 is less than its maximum.

If the amplification factor is too large, then a range of signals output by the amplifier 61 would correspond to the upper limit of the input range for the ADC 62. This would result in a loss of information in the image. Higher value signals would be mapped to the same value in the serialized signals. The higher value signals would not be distinguishable from each other in the image.

By providing that the amplifier 61 is tunable, the loss in information can be reduced. An embodiment of the invention is expected to achieve a higher resolution image of the sample 208.

In an embodiment, the detector array 240 is configured to detect charged particles with reference to their charge, i.e. directly. Such a detector may be referred to as a direct current detector. In a different embodiment, the detector array 240 may be configured to detect charged particles by reference to the energy of the charged particle, i.e. dependent on a band gap.

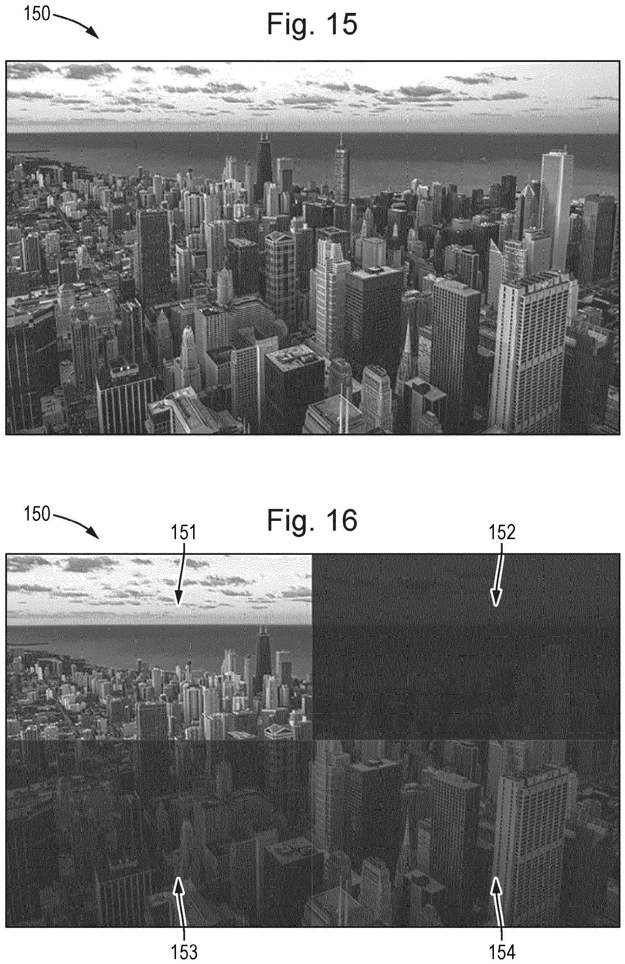

**FIG. 15** is an exemplary image 150. The image 150 has desirably high resolution. Each pixel of the image has the same number of possible gradations on the grayscale. Note that each pixel may correspond to the signal from a detector element, or a group of detector elements. **FIG. 16** is an alternative version of the image 150 shown in **FIG. 15****.** The image 150 shown in **FIG. 16** comprises four distinct quadrants 151-154. The different quadrants 151-154 correspond to different amplification factors. The top left quadrant 151 shows data received via an optimally tuned amplification factor. Each pixel in the top left quadrant 151 has the maximum number of grayscale gradations, similar to the image of **FIG. 15****.** The other three quadrants 152-154 are based on data for which the amplification factor is too low. The top right quadrant 152 corresponds to the lowest amplification factor. As a result of the lower amplification factors, the pixels appear darker than in the optimal image. Additionally, the pixels have a smaller number of possible grayscale gradations. The gradations at the white end of the scale are not possible. The image shown in **FIG 16** can be considered as a pictorial representation of a detector array with four detector elements each having a different strength.

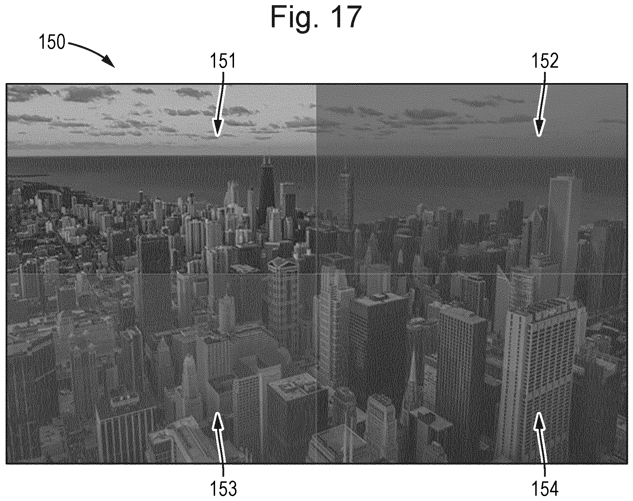

**FIG. 17** is a modified version of the image 150 shown in **FIG. 16****.** The data used to form the image 150 of **FIG. 16** has been post-processed (i.e. processing downstream in the data path of the amplification and the ADC) so as to improve the brightness ranges in the quadrants 151-154. As a result, the grayscale gradations at the white end of the grayscale are possible. However, the number of possible grayscale gradations in each of the quadrants 152-154 in the image 150 of **FIG. 17** is the same as in the image 150 of **FIG. 16****.** Visually, the resulting image shown in **FIG. 17** has poorer contrast comparted to **FIG. 15****.** **FIG. 17** demonstrates pictorially the correction in the data path following the amplifier and ADC of the variance in signal strength from detector elements, at the cost of signal resolution loss. Therefore, the resolution of the signal used to generate the image 150 is not improved by the post-processing. That is the loss in signal, as shown by the restricted range in grey scale values, is not recovered by the post-processing. This is represented by the restricted range of grey scale in the image of **FIG. 17** and the number of grey scale graduations it has compared to **FIG. 15****.**

In the same way as depicted in **FIGs. 15-17****,** when different amplifiers 61 have different amplification factors (for example in view of the variance in signal strength from detector elements), the image quality is reduced (e.g. as shown in **FIG. 16**). Although post-processing on the digital signal can be used so that an increased input range from the ADCs 62 is used to achieve an increased output signal range, information is lost and signal resolution is limited (e.g. as shown in **FIG. 17**).

In an embodiment, the ADC 62 is in data communication with the amplifier 61. The ADC 62 is configured to convert signals from the detector array 240 to a digital output. In an embodiment the amplifier 61 is configured to be tunable in order to tune the amplification of the signals from the detector array 240 so as to increase a proportion of an input range of the ADC 62 used. According to an embodiment, by tuning the amplifiers 61, an embodiment of the invention is expected to achieve images of the sample 208 having a greater amount of information.

**FIG. 11** is a schematic diagram of part of the circuit shown in **FIG. 10** according to an embodiment. In an embodiment the circuit comprises a calibrator 82. The calibrator 82 is configured to tune the amplifier 61 in order to tune the amplification of the signals from the detector array 240. In an embodiment the calibrator 82 is configured to tune the amplifier 61 in order to tune the amplification of the signals from the detector array 240 so as to equalise a proportion of an input range of the ADC 62 used by signals from the detector array 240. An embodiment of the invention is expected to achieve images in which the number of possible gradations for each section of the image is the same. In an embodiment the number of possible gradations is optimized. In an embodiment the circuit comprises a switch 81 configured to control the calibrator 82. For example, the switch 82 may comprise a button that can be pressed to initiate a calibration process.

As shown in **FIG. 11**, in an embodiment the amplifier 61 comprises a feedback resistor 70 configured to determine an amplification factor of the amplifier 61. In an embodiment the feedback resistor 70 is variable. By adjusting the resistance value of the feedback resistor 70, the amplification factor applied by the amplifier 61 can be controlled.

The feedback resistor 70 may comprise a plurality of components. For example, in an embodiment the feedback resistor 70 comprises a fixed resistor 71 and a variable resistor 72. The fixed resistor 71 and the variable resistor 72 are connected in series. By adjusting the resistance value of the variable resistor 72, the amplification factor applied by the amplifier 61 is controlled. The resistance value of the fixed resistor 71 is not changed. By providing a fixed resistor 72 as part of the feedback resistor 70, the amplification factor can be controlled more accurately. By providing the fixed resistor 71, the variable resistor 72 can have a lower maximum resistance value. As a result, proportional adjustments to the variable resistor 72 have a smaller effect on the total resistance value of the feedback resistor 70. The resistance value of the feedback resistor 70 can be controlled more finely by adjusting the variable resistor 72. However, in an alternative arrangement, the fixed resistor 71 may not be provided.

In an embodiment the fixed resistor 71 has a higher resistance value than the variable resistor 72. For example, in an embodiment the fixed resistor 71 has a resistance value that is at least two times, optionally at least four times and optionally at least eight times the maximum resistance value of the variable resistor 72. An embodiment of the invention is expected to improve the accuracy with which the amplifier 61 can be controlled.

In an embodiment, the resistance value of the feedback resistor 70 depends on an applied electrical potential. This is a system control signal applied back to the feedback resistor. By applying an electrical potential of a particular value, the amplification factor of the amplifier 61 can be controlled. For example, a DC may be applied to the amplifier 61 to control its amplification factor.

It should be noted that the calibrated signal should be tuned to optimize the signal to noise ratio. In using higher resistance, higher amplification can be achieved. In using a feedback system (i.e. connecting the output to the input) the system may hold itself stable - this is how in principle an amplifier works. Thus the input current, e.g. detector signal, is amplified by the resistance to generate the voltage, i.e. the output electric potential to the ADC . However, there is an impact in using a larger resistor in terms of the noise contribution, i.e. the signal to noise ratio . In using a small current, such as likely to be provided by a detector element, such as capture electrode, there is a consequence of a thermal noise contribution from the resistor, which is significant in view of the size of the amplified signal. The signal of course represents the current. Because the signal to noise relationship tends to be linear, whereas the noise is proportional to the square root [of the measured current], the signal to noise ratio can be improved in the amplification. Thus the resistance value is preferably large to improve the amplification. This will enable an input signal to be generated towards the upper limit of the input range of the ADC. Yet there is a risk that the noise level will be too high a proportion relative to the signal. Thus the invention uses the tunable resistor to maximize the ADC range taking into account the risk of introducing noise; hence the trade off by tuning.

In an embodiment the feedback resistor 70 comprises a sample and hold circuit 73 configured to hold the applied electrical potential so as to maintain the resistance value of the feedback resistor 70. For example, the potential may be applied when calibrating the image processing system. In an embodiment the electrical potential is applied locally to the feedback resistor 70. Once the electrical potential is set, the sample and hold circuit 73 holds the potential to its value. The applied potential may be held until a subsequent calibration process. In an embodiment the sample and hold circuit 73 is configured to hold the value of the potential for at least an hour, optionally at least a day, and optionally at least a month. An embodiment of the invention is expected to reduce the burden of calibrating the image processing system.

In an embodiment the circuit 60 comprises an electrical potential applicator 83 configured to apply the electrical potential so as to determine the resistance value of the feedback resistor 70. In an embodiment the electrical potential applicator 83 comprises a digital-to-analog converter (DAC) configured to convert a digital calibration signal into an analog DC voltage. In an embodiment the calibrator 82 is configured to output the calibration signal to the electrical potential applicator 83.

In an embodiment the circuit 60 comprises a multiplexer 84 configured to control application of the electrical potential by the electrical potential applicator 83 for each of a plurality of amplifiers 61 for respective detector elements 405 of the detector array 240 in turn. The multiplexer 84 is configured to distribute the voltage to the relevant feedback resistor 70 at the required time. By providing the multiplexer 84, it is possible to reduce the number of different power supplies required to apply independent voltages.

In an embodiment at least an element of the circuit 60 is associated with the detector array 240. For example, one or more of the amplifier 61, the ADC 62, the calibrator 82, the switch 81, the multiplexer 84 and the electric potential applicator 83 may be associated with the detector array 240. In an embodiment, at least an element of the circuit 60 is incorporated in the logic layer 407. Additionally or alternatively, in an embodiment at least an element of the circuit 60 is associated with the controller 50.

In an embodiment at least an element of the circuit 60 is structurally integrated into the detector array 240. In an embodiment, for example as shown in and described with reference to **FIGs. 3** and **9** the detector array is part of an assembly for an electron optical component such as an objective lens array assembly. In an embodiment at least an element of the circuit 60 may be integrated into a detector arrangement forming part of the objective lens array arrangement and/or a generic part of the objective lens array arrangement, i.e. that is not specifically assigned to the detector.

By being associated with the electron-optical column, the elements of the circuit 60 may be within the column avoiding a need for a feedthrough to ambient atmosphere. Each additional connection through the wall of a vacuum chamber, and thus increase in feedthrough demand, may risk the integrity of the vacuum and/or may increase design complexity. An embodiment of the invention is expected to make it easier to manufacture and/or maintain the electron beam tool 40.

By providing that the circuit 60 is proximate to the detector array 240, wiring routing is reduced. An embodiment of the invention is expected to reduce complexity of the electron beam tool 40 and to reduce the distance the signal needs to be transmitted, thereby making for a more efficient arrangement. Such risks in complexity may thus concern the data path which may impact tool performance.

In an embodiment at least one of the elements of the circuit 60 is integrated into the structural hardware associated with the objective lens array assembly. In an embodiment at least one of the elements of the circuit 60 is integrated into the logic layer 407 of the detector array 240.

**FIG. 12** schematically depicts an electron beam tool 40 according to an embodiment. Features that are the same as those described above are given the same reference numerals. For conciseness, such features are not described in detail with reference to **FIG. 12****.** For example, the source 201, the condenser lenses 231, the macro collimator 270, the objective lens array 241 and the sample 208 may be as described above.

As described above, in an embodiment the detector array 240 is between the objective lens array 241 and the sample 208. The detector array 240 may face the sample 208. Alternatively, as shown in **FIG. 12**, in an embodiment the objective lens array 241, which comprises the plurality of objective lenses, is between the detector array 240 and the sample 208.

In an embodiment a deflector array 95 is between the detector array 240 and the objective lens array 241. In an embodiment the deflector array 95 comprises a Wien filter so that deflector array may be referred to as a beam separator. The deflector array 95 is configured to provide a magnetic field to disentangle the charged particles projected to the sample 208 from the secondary electrons from the sample 208.

In an embodiment the detector array 240 is configured to detect charged particles by reference to the energy of the charged particle, i.e. dependent on a band gap. Such a detector may be called an indirect current detector. The secondary electrons emitted from the sample 208 gain energy from the fields between the electrodes. The secondary electrons have sufficient energy once they reach the detector array 240.

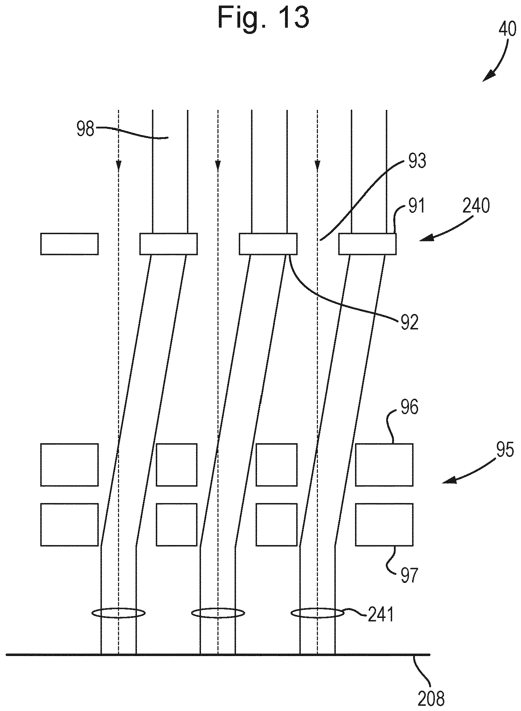

**FIG. 13** is a close-up view of part of the electron beam tool 40 shown in **FIG. 12****.** In an embodiment the detector array 240 comprises an electron to photon converter array 91. The electron to photon converter array 91 comprises a plurality of fluorescent strips 92. Each fluorescent strip 92 is located in the plane of the electron to photon converter array 91. At least one fluorescent strip 92 is arranged between two adjacent charged particle beams projected towards the sample 208.

In an embodiment, the fluorescent strips 92 extend substantially in the horizontal direction. Alternatively, the electron to photon converter array 91 may comprise a plate of a fluorescent material with openings 93 for the projected charged particle beams.

The projected charged particle beams, indicated by dashed lines in **FIG. 13**, are projected through the plane of the electron to photon converter array 91, via the openings 93 between the fluorescent strips 92, towards the deflector array 95.

In an embodiment the deflector array 95 comprises a magnetic deflector 96 and an electrostatic deflector 97. The electrostatic deflector 97 is configured to counteract the deflection of the magnetic deflector 96 for the projected charged particle beams transmitted towards the sample 208. Accordingly, the projected charged particle beams may be shifted to a small extent in the horizontal plane. The beams down-beam of the deflector array 95 are substantially parallel to the beams up-beam of the deflector array 95.

In an embodiment the objective lens array 241 comprises a plurality of plates for guiding secondary electrons created in the sample 208 towards the deflector array 95. For the secondary electrons, which travel in opposite direction with respect to the projected charged particle beams, the electrostatic deflector 97 does not counteract the deflection of the magnetic deflector 96. Instead, the deflections of the secondary electrons by the electrostatic deflector 97 and the magnetic deflector 96 add up. Accordingly, the secondary electrons are deflected to travel at an angle with respect to the optical axis in order to transmit the secondary electrons onto the fluorescent strips 92 of the detector array 240.

At the fluorescent strips 92, photons are created upon incidence of the secondary electrons. In an embodiment, the photons are transported from the fluorescent strip 92 to a photo detector (not shown) via a photon transport unit. In an embodiment, the photon transport unit comprises an array of optical fibers 98. Each optical fiber 98 comprises an end which is arranged adjacent or attached to one of the fluorescent strips 92 for coupling photons from the fluorescent strip 92 into the optical fiber 98, and another end which is arranged to project photons from the optical fiber 98 onto the photo detector.

**FIG. 14** schematically depicts an electron beam tool 40 according to an embodiment. As described above, in an embodiment the detector array 240 is aligned with the main electron-optical axis of the electron beam tool 40. Alternatively, the detector array 240 may be aligned with a different axis, as shown in **FIG. 14****.**

Features that are the same as those described above are given the same reference numerals. For conciseness, such features are not described in detail with reference to **FIG. 14****.** For example, the source 201, the primary electron beam 202, the sub-beams 211, 212 and 213, the projection apparatus 230, the condenser lenses 231, the probe spots 221, 222, 223, the controller 50, the sample 208, the sample holder 207, the motorized stage 209 and the detector array 240 may be as described above.

The electron source 201, a gun aperture plate 271, a condenser lens 210 and a source conversion unit 220 are components of an illumination apparatus comprised by the electron beam tool 40. The gun aperture plate 271, in operation, is configured to block off peripheral electrons of primary electron beam 202 to reduce the Coulomb effect. The gun aperture plate 271 may be referred to as a Coulomb Aperture Array. The Coulomb effect may enlarge the size of each of probe spots 221, 222, and 223 of primary sub-beams 211, 212, 213, and therefore deteriorate inspection resolution. A gun aperture plate 271 may also include multiple openings for generating primary sub-beams (not shown) even before the source conversion unit 220 and may be referred to as a coulomb aperture array.

The condenser lens 210 is configured to focus (or collimate) primary electron beam 202. In an embodiment of the source conversion unit 220, the source conversion unit 220 may comprise an image-forming element array, an aberration compensator array, a beam-limit aperture array, and a pre-bending micro-deflector array. The pre-bending micro-deflector array may, for example, be optional and may be present in an embodiment in which the condenser lens does not ensure substantially normal incidence of sub-beams originating from the coulomb aperture array onto e.g. the beam-limit aperture array, the image-forming element array, and/or the aberration compensator array.

The electron beam tool 40 may comprise a secondary projection apparatus 255 associated with the detector array 240. The primary projection apparatus 230 may comprise an array of condenser lenses 231 which may be magnetic, which may function as an objective lens. A beam separator 233 and a deflection scanning unit 232 may be positioned inside primary projection apparatus 230. The beam separator 233 may comprise a Wien filter. The detector array 240 may comprise a plurality of detector elements 405.

The components that are used to generate a primary beam may be aligned with a primary electron-optical axis 204 of the electron beam tool 40. These components may include: the electron source 201, the gun aperture plate 271, the condenser lens 210, the source conversion unit 220, the beam separator 233, the deflection scanning unit 232 and the primary projection apparatus 230. The secondary projection apparatus 255 and its associated detector array 240 may be aligned with a secondary electron-optical axis 251 of the electron beam tool 40.

In the current embodiment, the secondary electrons propagate in three secondary electron beams 261, 262, and 263. The secondary projection apparatus 255 subsequently focuses the path of secondary electron beams 261, 262, and 263 onto a plurality of detector elements 405 of the detector array 240.

The detector elements 405 may detect the secondary electron beams 261, 262, and 263. On incidence of secondary electron beams with the detector elements 405, the elements may generate corresponding intensity signal outputs (not shown). In an embodiment, the detector elements may be capture electrodes. The outputs may be directed to the image processing system.

An assessment tool according to an embodiment of the invention may be a tool which makes a qualitative assessment of a sample (e.g. pass/fail), one which makes a quantitative measurement (e.g. the size of a feature) of a sample or one which generates an image of map of a sample. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools)..

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

While the present invention has been described in connection with various embodiments, other embodiments of the invention will be apparent to those skilled in the art from consideration of the specification and practice of the invention disclosed herein.

For example, although the description above is directed to amplification of the current of secondary electrons using TIAs, the skilled person knows of other types of circuitry that can perform the tunable amplification. Other topologies comprising an operational amplifier and a feedback resistor, such as an integrator variant or a current-to-voltage converter, can perform the tunable amplification.

The invention can be applied to various sorts of detector array 240. For example, capture electrodes for example to detect directly electron charge, scintillators or PIN elements can be used. The detector array 240 may be a direct current detector or an indirect current detector.

The invention can be applied to detector arrays 240 at various locations in the electron beam tool 40. For example, the detector array 240 may be associated with the objective lens array 241 at the bottom of the column or may be higher-up than the bottom of the column, for example associated with an objective lens array 241 above the bottom of the column, located elsewhere in a primary column (e.g. as shown in **FIG 12**) or in a secondary column (e.g. as shown in **FIG. 14**).

In an embodiment the circuit 60 that embodies at least part of the image processing system is part of the objective lens array assembly. The circuit 60 may be built into the mechanical design of the objective lens array assembly. In an embodiment, the objective lens array assembly comprises the control lens array 250, pre-limiter array (which may be associated with the control lens array 250 as shown in **FIG. 9**), the objective lens array 241, a beam shaping array (which may be associated with the objective lens array 241 as shown in **FIG. 9**) and the detector array 240. Alternatively, the objective lens array assembly may comprise the control lens array 250, the objective lens array 241 and the detector array 240. The function of the pre-limiter array and the beam shaping array (or final beam limiting array) may be performed by an aperture array associated with the condenser lenses 231 (e.g. see **FIG. 3**).

The invention can be applied to various different tool architectures. For example, the electron beam tool 40 may be a single beam tool, or may comprise a plurality of single beam columns or may comprise a plurality of columns of multi-beams.

Any element or collection of elements may be replaceable or field replaceable within the electron beam tool 40. The one or more electron-optical components in the electron beam tool 40, especially those that operate on sub-beams or generate sub-beams, such as aperture arrays and manipulator arrays may comprise one or more MEMS.

There is provided the following clauses:
Clause 1: A multi-beam electron-optical system for a charged-particle assessment tool, the system comprising: an objective lens array assembly comprising a plurality of objective lenses, each configured to project one of a plurality of charged-particle beams onto a sample; a detector array associated with the objective lens array assembly and configured to detect charged-particles emitted from the sample; and a circuit comprising an amplifier in data communication with the detector array of detector elements; wherein the amplifier is configured to be tunable in order to tune amplification of signals from the detector array.
Clause 2: The multi-beam electron-optical system of clause 1, wherein the detector array is a current detector array configured to detect the charged-particles by reference to their charge.
Clause 3: A multi-beam electron-optical system for a charged-particle assessment tool, the system comprising: a current detector array configured to detect charged-particles emitted from a sample by reference to their charge; and a circuit comprising an amplifier in data communication with the detector array of detector elements; wherein the amplifier is configured to be tunable in order to tune amplification of signals from the detector array.
Clause 4: The multi-beam electron-optical system of clause 3, comprising: an objective lens array assembly comprising a plurality of objective lenses, each configured to project one of a plurality of charged-particle beams onto a sample; wherein the detector array is associated with the objective lens array assembly.
Clause 5: The multi-beam electron-optical system of any of clauses 1, 2 and 4, wherein the detector array is between the plurality of objective lenses and the sample.
Clause 6: The multi-beam electron-optical system of clause 5, wherein the detector array faces the sample.
Clause 7: The multi-beam electron-optical system of any of clauses 1, 2 and 4, wherein the plurality of objective lenses is between the detector array and the sample.
Clause 8: The multi-beam electron-optical system of any of clauses 1-4 and 7, comprising: a secondary projection apparatus aligned with a secondary electron-optical axis of the charged-particle assessment tool, wherein the detector array is associated with the secondary projection apparatus.
Clause 9: The multi-beam electron-optical system of any preceding clause, the circuit comprising: an analogue to digital converter in data communication with the amplifier to convert signals from the detector array to a digital output; wherein the amplifier is configured to be tunable in order to tune the amplification of the signals from the detector array so as to increase a proportion of an input range of the analogue to digital converter used.
Clause 10: The multi-beam electron-optical system of any preceding clause, the circuit comprising: a calibrator configured to tune the amplifier in order to tune the amplification of the signals from the detector array so as to equalise a proportion of an input range of the analogue to digital converter used by signals from the detector array.
Clause 11: The multi-beam electron-optical system of clause 10, the circuit comprising: a switch configured to control the calibrator.
Clause 12: The multi-beam electron-optical system of any preceding clause, wherein the amplifier comprises a feedback resistor configured to determine an amplification factor of the amplifier.
Clause 13: The multi-beam electron-optical system of clause 12, wherein the feedback resistor is variable.
Clause 14: The multi-beam electron-optical system of clause 13, wherein the feedback resistor comprises a fixed resistor and a variable resistor.
Clause 15: The multi-beam electron-optical system of clause 14, wherein the fixed resistor has a higher resistance value than the variable resistor.
Clause 16: The multi-beam electron-optical system of any of clauses 13-15, wherein a resistance value of the feedback resistor depends on an applied electrical potential.
Clause 17: The multi-beam electron-optical system of clause 16, wherein the feedback resistor comprises a sample and hold circuit configured to hold the applied electrical potential so as to maintain the resistance value of the feedback resistor.
Clause 18: The multi-beam electron-optical system of clause 16 or 17, the circuit comprising: an electrical potential applicator configured to apply the electrical potential so as to determine the resistance value of the feedback resistor.
Clause 19: The multi-beam electron-optical system of clause 18, wherein the electrical potential applicator comprises a digital to analogue converter configured to output the electrical potential.
Clause 20: The multi-beam electron-optical system of clause 18 or 19, the circuit comprising: a multiplexer configured to control application of the electrical potential by the electrical potential applicator for each of a plurality of amplifiers for respective detector elements in turn.
Clause 21: The multi-beam electron-optical system of any preceding clause, wherein the detector array comprises a metal member configured to receive the charged-particles emitted from the sample.
Clause 22: The multi-beam electron-optical system of any of clauses 1-20, wherein the detector array comprises a scintillator or an array of PIN elements.
Clause 23: The multi-beam electron-optical system of any preceding clause, wherein at least an element of the circuit is associated with the detector array.
Clause 24: The multi-beam electron-optical system of any preceding clause, wherein at least an element of the circuit is structurally integrated into the detector array.
Clause 25: A method for assessing a sample surface with a plurality of sub-beams, the method comprising: projecting, by use of an objective lens array assembly, the sub-beams onto a surface of a sample; detecting, by a detector array associated with the objective lens array assembly, charged-particles emitted from the sample; and amplifying, by an amplifier, signals from the detector array, wherein the amplifier is configured to be tunable in order to tune the amplification of the signals from the detector array.
Clause 26: A method for assessing a sample surface with a plurality of sub-beams, the method comprising: projecting the sub-beams onto a surface of a sample; detecting, by a detector array, a current charged-particles emitted from the sample by reference to their charge; and amplifying, by an amplifier, signals from the detector array, wherein the amplifier is configured to be tunable in order to tune the amplification of the signals from the detector array.
Clause 27: An image of a sample formed from data from a charged-particle assessment tool, the image comprising: a plurality of image areas formed from data from respective detectors of the charged-particle assessment tool, the data indicating a current of charged-particles emitted from a respective area of the sample, wherein the image areas comprise the same number of gradations corresponding to different currents of charged-particles emitted from the sample.

It is intended that the specification and examples be considered as exemplary only, with a true scope and spirit of the invention being indicated by the following claims and clauses provided herein.

## Claims

1. A multi-beam electron-optical system for a charged-particle assessment tool, the system comprising:
an objective lens array assembly comprising a plurality of objective lenses, each configured to project one of a plurality of charged-particle beams onto a sample;
a detector array associated with the objective lens array assembly and configured to detect charged-particles emitted from the sample; and
a circuit comprising an amplifier in data communication with the detector array of detector elements;
wherein the amplifier is configured to be tunable in order to tune amplification of signals from the detector array.

2. The multi-beam electron-optical system of claim 1, wherein the detector array is a current detector array configured to detect the charged-particles by reference to their charge.

3. The multi-beam electron-optical system of claim 1 or 2, the circuit comprising:
an analogue to digital converter in data communication with the amplifier to convert signals from the detector array to a digital output;
wherein the amplifier is configured to be tunable in order to tune the amplification of the signals from the detector array so as to increase a proportion of an input range of the analogue to digital converter used.

4. The multi-beam electron-optical system of any preceding claim, the circuit comprising:
a calibrator configured to tune the amplifier in order to tune the amplification of the signals from the detector array so as to equalise a proportion of an input range of the analogue to digital converter used by signals from the detector array.

5. The multi-beam electron-optical system of any preceding claim, wherein the amplifier comprises a feedback resistor configured to determine an amplification factor of the amplifier.

6. The multi-beam electron-optical system of claim 5, wherein the feedback resistor is variable, preferably the feedback resistor comprises a fixed resistor and a variable resistor, more preferably the fixed resistor has a higher resistance value than the variable resistor.

7. The multi-beam electron-optical system of claim 6, wherein a resistance value of the feedback resistor depends on an applied electrical potential, preferably the feedback resistor comprises a sample and hold circuit configured to hold the applied electrical potential so as to maintain the resistance value of the feedback resistor.

8. The multi-beam electron-optical system of claim 7, the circuit comprising:
an electrical potential applicator configured to apply the electrical potential so as to determine the resistance value of the feedback resistor, preferably the electrical potential applicator comprises a digital to analogue converter configured to output the electrical potential.

9. The multi-beam electron-optical system of claim 8, the circuit comprising:
a multiplexer configured to control application of the electrical potential by the electrical potential applicator for each of a plurality of amplifiers for respective detector elements in turn.

10. The multi-beam electron-optical system of any preceding claim, wherein the detector array comprises:
a metal member configured to receive the charged-particles emitted from the sample; or
a scintillator or an array of PIN elements.

11. The multi-beam electron-optical system of any preceding claim, wherein at least an element of the circuit is associated with the detector array.

12. The multi-beam electron-optical system of any preceding claim, wherein at least an element of the circuit is structurally integrated into the detector array.

13. The multi-beam electron-optical system of any preceding claim, wherein the detector array is between:
the plurality of objective lenses and the sample, preferably the detector array faces the sample; or.
the plurality of objective lenses is between the detector array and the sample.

14. The multi-beam electron-optical system of any of claims 1 or 12, comprising:
a secondary projection apparatus aligned with a secondary electron-optical axis of the charged-particle assessment tool,
wherein the detector array is associated with the secondary projection apparatus.

15. A method for assessing a sample surface with a plurality of sub-beams, the method comprising:
projecting, by use of an objective lens array assembly, the sub-beams onto a surface of a sample;
detecting, by a detector array associated with the objective lens array assembly, charged-particles emitted from the sample; and
amplifying, by an amplifier, signals from the detector array,
wherein the amplifier is configured to be tunable in order to tune the amplification of the signals from the detector array.
